(19) Europäisches Patentamt / European Patent Office / Office européen des brevets

(11) **EP 2 674 959 A1**

(12) **EUROPEAN PATENT APPLICATION**

(43) Date of publication:
**18.12.2013 Bulletin 2013/51**

(51) Int Cl.:
**H01J 37/153** (2006.01)

(21) Application number: **12171725.0**

(22) Date of filing: **13.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **FEI Company**
**Hillsboro, OR 97124-5793 (US)**

(72) Inventor: **Henstra, Alexander**
**3544 PW Utrecht (NL)**

(74) Representative: **Bakker, Hendrik**
**FEI Company**
**Patent Department**
**P.O. Box 1745**
**5602 BS Eindhoven (NL)**

(54) **Charged-particle apparatus equipped with improved Wien-type Cc corrector**

(57)     The invention relates to a charged-particle apparatus equipped with improved Wien-type $C_c$ corrector. A charged particle apparatus (TEM, STEM, SEM) with a double-focusing ExB filter as a corrector for an objective lens is known to the person skilled in the art. Inventors realized an improved corrector by introducing a drift space in the middle of the corrector, thereby dividing the corrector in two, preferably identical, modules. This results in a corrector with, for identical excitation, a larger negative $C_c$ and enables positioning an energy selective slit in the mid-plane, thus enabling the corrector to simultaneously act as an energy filter. A simulation of two ExB modules with a length of 25 mm, divided by a drift space of 10 mm, is discussed.

FIG. 3c

EP 2 674 959 A1

## Description

The invention relates to a charged-particle apparatus for inspecting or machining a sample, the charged-particle apparatus equipped with a charged particle source for producing a beam of charged particles, source optics, a $C_c$ corrector, and one or more lenses showing chromatic aberrations, where the $C_c$ corrector is a Wien-type $2\pi$ double-focusing corrector equipped to correct the chromatic aberrations of at least one of the lenses.

Such a charged-particle apparatus is known from European patent publication no. EP0868739B1.

The known patent discloses a charged-particle apparatus comprising a particle source producing a beam of particles along an axis, a focusing lens and a correcting device for correcting the lens aberrations of the focusing lens. The correcting device is equipped with an electrical dipole field E and a magnetic dipole field B, the electrical and the magnetic dipole fields perpendicular to the axis and perpendicular to each other (hence: Wien-type). The correcting device is further equipped with an electrostatic quadrupole for producing a focusing field, the length and strength of the quadrupole field such, that the particles of the beam describe a sinusoidal trajectory with one (or several) complete period(s). In the case of one complete period this makes the corrector a so-named $2\pi$ double-focusing corrector: $2\pi$ as the beam describes a complete sinusoid period and double-focusing as the corrector focuses in both the plane of the electric field and the plane of the magnetic field.

Such a charged-particle apparatus is also known from US patent publication no. US 8,035,082 B2. This patent discloses a defect inspection station in which a wafer is irradiated with particulate radiation (electrons), as a result of which electrons are emitted from said wafer. The wafer is immersed in the magnetic field of an immersion objective lens. The electrons are accelerated and focused by the objective lens and other imaging lenses on a detector. A Wien-type $2\pi$ double-focusing corrector comprising a multipole lens is used for correcting the chromatic aberration of the immersion objective lens.

For many types of inspection only charged particles with an energy within a predetermined energy band are needed. This is achieved with an energy filter, also known as a monochromator. As known to the person skilled in the art, examples where energy filtering is needed are, for example:

- analysis in a Transmission Electron Microscope (TEM) involving energy loss spectroscopy, where the beam impinging on the sample must be very monochromatic,
- defect inspection involving voltage contrast: to enable such analysis an energy filter, blocking charged particles with an unwanted energy, must be incorporated as well.
- Scanning Electron Microscopy (SEM) and Scanning Transmission Electron Microscopy (STEM) in which the energy spread of the beam probing the sample is so large that chromatic axial aberration occurs.

It is noted that a corrector does not diminish the amount of charged particles (the current) in the beam, but that a filter diminishes the current, as part of the charged particles are blocked.

It is further noted that, when the filter is used in a system where a source irradiates a sample, and the filter is used to lower the energy spread of the beam irradiating the, the filter is also referred to as a monochromator.

The invention intends to provide a corrector with integrated energy filter.

To that end a charged particle apparatus according to the invention is **characterized in that** the $C_c$ corrector comprises two separate modules, the two modules separated by a drift space, the first module between the source and the second module, each module formed as a $1\pi$ corrector, the image of the first module showing energy dispersion, said image acting as the object of the second module, said second module countering the chromatic dispersion of the first module, and an energy selecting diaphragm with an energy selecting aperture is located in the drift space between the two modules at the image of the first module, as a result of which the $C_c$ corrector is equipped to act as an energy filter.

The invention is based on the insight that the $2\pi$ double-focusing corrector shows a mid-plane where energy dispersion occurs. By forming the corrector from two modules, each a $1\pi$ corrector, the first module forms a focus showing energy dispersion at the mid-plane, said energy dispersion eliminated at the second focus formed by the second module. An energy selecting diaphragm is placed in the mid-plane, the diaphragm showing an aperture. Due to the energy dispersion only charged particles with an energy within an energy band are transmitted by the aperture in the diaphragm, while charged particles with an energy outside said energy band are blocked.

It is noted that the aperture can have one of many forms, including a round form, a square opening or a slit in the diaphragm.diaphragm can act as a band-pass filter, but when for example formed as a single knife edge, also as a high- or low-pass filter.

Such a diaphragm or slit should be a conductive, non-charging, diaphragm or slit, and thus such a diaphragm or slit must be positioned in a region of the corrector without electric field. Therefore the two modules of the corrector are separated by a drift space, with the diaphragm or slit placed in this drift space.

Preferably the two modules of the corrector are identical to each other.

Such a corrector shows residual aberrations, such as axial chromatic astigmatism at the exit plane of the corrector/filter. By introducing a hexapole field in the first and the second module, these residual aberrations can be greatly reduced. Said hexapole field can be either a magnetic or an electrostatic hexapole field, and has a substantially identical orientation in both modules.

It is noted that when eliminating axial chromatic aberration the next aberration that occurs is coma. This aberration causes an aberration figure in the mid plane, and is eliminated in the exit plane due to symmetry.

To limit the voltages used in the corrector, it may be beneficial to place the corrector at a position where the charged particles have a relatively low energy, for example less than 10 keV, and then post-accelerate the charged particles to their final energy. It is noted that in e.g. a TEM the post-acceleration typically results in electrons with a selectable energy between 80 keV and 300 keV, or even more. A reason for limiting the energy with which the particles travel through the corrector may be that, when higher energies are used, for example magnetic saturation occurs in the magnetic circuit, or the electric potentials becomes so high that flash-over occurs. Also, the reduced beam energy results in less stringent requirements of stabilities of the voltage sources and current sources needed for the excitation of the multipoles, as known from US patent application number US20080290264 A1, more specifically in its paragraph [0051].

When post-accelerating the beam to a selectable energy, the charged particles preferably have a fixed potential in the corrector, said fixed potential independent from the energy of the particles after post-acceleration.

It is noted that when using very low voltages, for example in Scanning Electron Microscopes (SEM) forming an image with a focused beam of electrons with an energy of 200 eV or less, it may be beneficial to correct/filter at a higher beam energy than the energy with which the electrons impinge on the sample. One reason is, for example, magnetic hysteresis effects in the magnetic pole faces of the magnetic multipoles, which are particularly problematic at low energies, as then very low magnetic fields are required.

To position the image formed by the first module on the energy selecting slit or aperture, the first module may comprise one or more deflectors. If needed, similar deflectors may be incorporated in the second module to counter the effect of the deflectors in the first module, so that the exiting beam is always on the same position, independent from the deflection by the deflectors in the first module.

It is noted that preferably the first and the second module each comprise two deflectors, the two deflectors cooperating so that the beam impinges substantially perpendicular to the mid-plane.

It is further noted that the use of deflectors enables the positioning of the beam on an aperture plate with several apertures or slits, the different apertures or slits having different sizes corresponding to different energy pass bands. In a preferred embodiment one of these apertures of slits is sufficiently large to pass substantially all particles (when the beam is positioned on this aperture or slit), in which case no energy filtering and thus no beam current loss occurs.

Instead of a point focus at the mid-plane a line focus (astigmatic focus) may be formed. The advantage of a line focus is that the current density in the line focus is less, and therefore interaction between charged particles (e.g. Boersch effect) is less. In this case each of the modules is not double-focusing (hence the line focus), but the complete corrector/filter is double focusing (focusing in both directions).

Preferably the charged-particle apparatus is a Scanning Electron Microscope (SEM), a Transmission Electron Microscope (TEM), a Scanning Transmission Electron Microscope (STEM), a Focused Ion Beam (FIB) machine, or a combination thereof, such as a machine equipped with both an ion beam column and an electron beam column.
Such an apparatus has a ion source or an electron source for producing the beam of charged particles, although also a cluster source, producing a charged molecule, can be used.
The beam of charged particles produced by the source is directed to the sample and impinges on the sample. Demagnifying optics (condenser lenses) are typically placed between the particle source and the corrector/filter.

In probe forming systems (SEM, STEM, FIB) an image of the charged particle source is focused on the sample. In the instrument according to the invention the beam focused on the sample is first directed through the corrector/filter.

In TEM the sample is placed between the source and the corrector/filter, resulting in lens correction by the correcting action of the corrector/filter and selection of a part of the transmitted electrons by the filter action of the corrector/filter, the selection based on the energy loss of the electrons transmitted through the sample.

It is noted that in this mode (TEM mode with the sample between particle source and corrector/filter) the image at the mid-plane of the corrector/filter is an image of the sample, or more precise: the part of the sample that is imaged. As a consequence the size of the energy selective aperture or slit cannot be chosen smaller than the size of said image, and the energy selection will be a coarse selection, and the passed energy band is a function of the position in the image.

It is clear that for a probe forming system (e.g. a STEM) a corrector/filter between particle source and sample the device acts as a corrector and a filter, while the device only acts as a filter when placed between sample and final image. For a non-probe forming system (i.e. a TEM) a device positioned between the sample and the final image acts as a corrector and a filter, while a device positioned between particle source and the sample only acts as a filter. A versatile (S)TEM, an apparatus equipped to operate as both a TEM and a STEM, may thus well be equipped with two filter/correctors.

It is noted that the magnification between the corrector and the lens should be 0.1<|M|<10 and more preferably 0.5<|M|<2, as otherwise the diameter of the beam in the corrector becomes too large or too small compared to its diameter in the lens. Too large a diameter implies that the beam comes close to the pole faces and electrodes of the multipoles of the corrector, resulting in aberrations. These aberrations are a result of higher order aberrations terms and are due to higher order multipole terms. Too small a diameter implies high magnetic and electric fields in the corrector, resulting in magnetic saturation effects and/or electric flash-overs.

In a defect inspection station as disclosed in US 8,035,082 B2, discussed earlier, the sample acts as the charged particle source, and the chromatic aberrations of the immersion objective lens are corrected. An enlarged image of the sample is imaged on a detector, for example a fluorescent screen or a CMOS camera.

The filter adds e.g. voltage contrast capability to such a station by selectively passing only electrons with an energy above (or below) a certain threshold value. By for example comparing an image in which all secondary electrons are imaged, and an image where only secondary electrons with an energy above 2.5 eV are imaged, tracks with a potential of 5 V can be easily distinguished from tracks with a potential of 0 V.

It is noted that, as is the case in a TEM, in this mode the image at the mid-plane of the corrector/filter is an image of the sample, or more precise: the part of the sample that is imaged. As a consequence the size of the energy selective aperture or slit cannot be chosen smaller than the size of said image, and the energy selection will be a coarse selection, and the passed energy band is a function of the position in the image.

The invention is now elucidated using figures, in which identical reference numerals indicate corresponding features. To that end:

- Figure 1 schematically shows a TEM equipped with a corrector/monochromator
- Figure 2$^a$ schematically shows a prior art $C_c$ corrector of the double-focusing ExB type

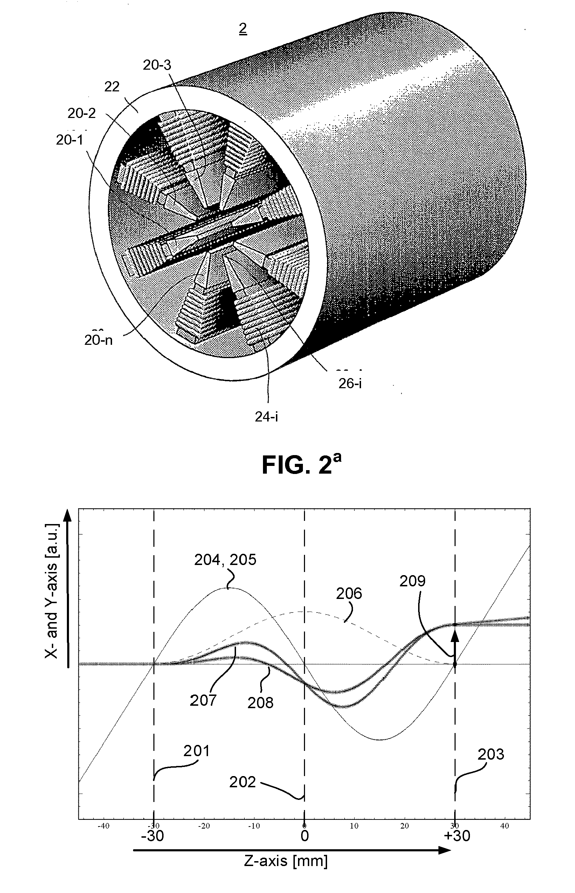

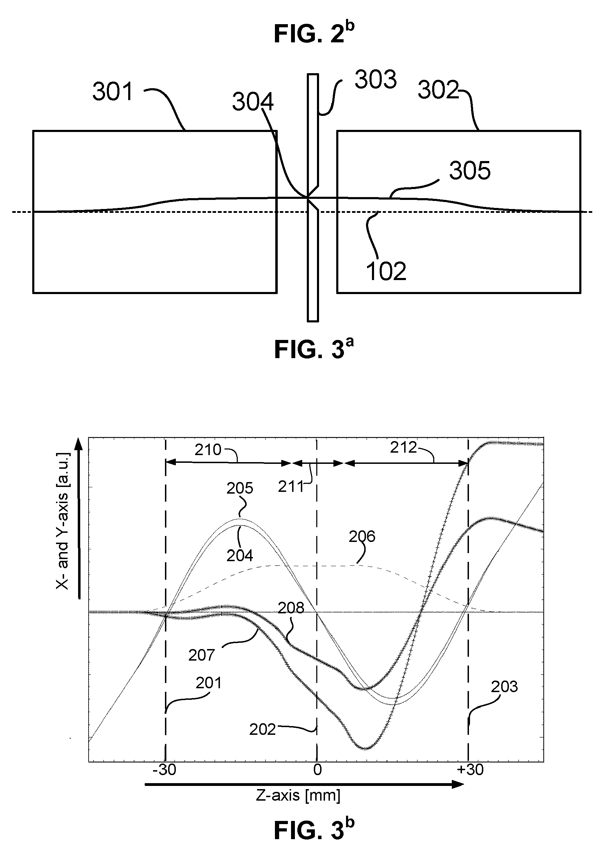

- Figure 2$^b$ schematically show the fundamental rays of the corrector of figure 2$^a$

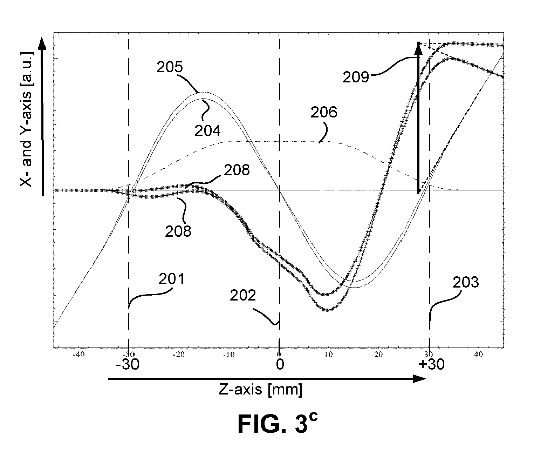

- Figure 3$^a$ schematically shows a $C_c$ corrector/monochromator according to the invention
- Figure 3$^b$ schematically shows the fundamental rays of the corrector
- Figure 3$^c$ schematically shows the fundamental rays of the corrector with an added hexapole

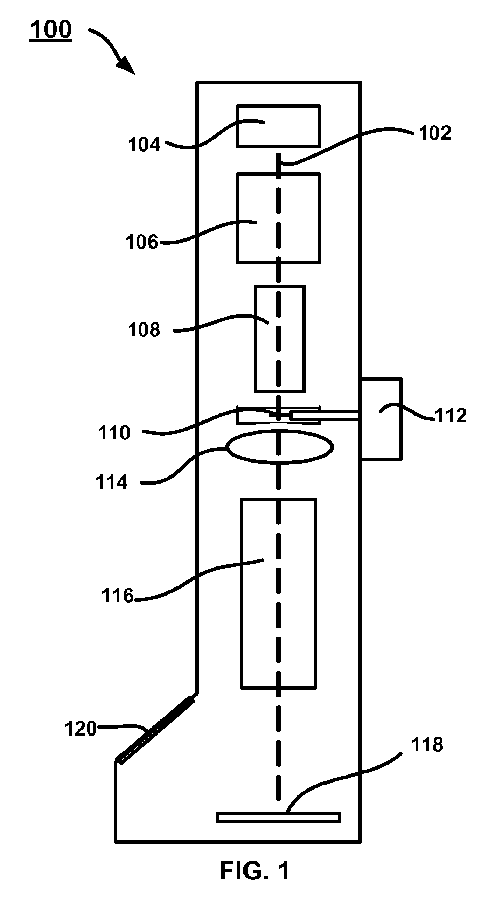

Figure 1 schematically shows a TEM 100 equipped with a corrector/filter according to the invention.

Figure 1 shows a particle source 104 producing a beam of particles, such as electrons, along optical axis 102. The particles have a selectable energy of typically between 80 - 300 keV, although higher energies, e.g. 400 keV - 1 MeV, or lower energies, e.g. 50 keV, may be used. The beam of particles is manipulated by condenser system 106 to form, in cooperation with the corrector/filter 108, a parallel beam impinging on a sample 110. The beam shows, due to the filtering action of corrector/filter 108, after being passed through the corrector/filter a lower energy spread than the beam entering the corrector/filter.

The sample positioned with a sample holder 112. The sample holder can position the sample with respect to the optical axis and may shift the sample in the plane perpendicular to the optical axis and tilt the sample with respect to said axis. Objective lens 114 forms a magnified image of the sample. The objective lens shows aberrations, among which chromatic aberrations. Due to the corrector/filter 108 the chromatic aberration is corrected.

The objective lens is followed by a magnifying system 116 forming an enlarged image of the sample on a detector 118, thereby revealing sample details of e.g. 0.1 nm. The detector may take the form of a fluorescent screen, or e.g. a CCD or CMOS camera. In the case of e.g. a fluorescent screen the screen can be viewed via the glass window 120.

It is noted that similar prior art microscopes are commercially available in which the corrector/filter lacks the filtering actions, e.g. in which element 108 is only a corrector for the chromatic aberration of the objective lens 114.

In a TEM (non-probe forming system) the corrector/filter 108 is placed between objective lens 114 and imaging optics (magnifying system) 116.

It is mentioned that a Scanning Electron Microscope (SEM) equipped with a corrector of the double focusing ExB type is known from US patent No. US5,986,269. The person skilled in te art will recognize that the corrector shown there can be exchanged for the corrector/filter discussed in this invention.

It is further mentioned that, although apparatuses using a beam of electrons is most widely used, also apparatuses employing a beam of ions are known, more specifically apparatuses in which a beam of ions is scanned over the surface of a sample. Such an apparatus, commonly known as a FIB (Focused Ion Beam apparatus) may also be equipped with a corrector/filter according to the invention.

Figure 2$^a$ schematically shows a prior art $C_c$ corrector of the double-focusing ExB type.

The corrector $\underline{2}$ shown in figure 2$^a$ is formed by a magnetic circuit which consists of a cylindrical jacket 22 in which a number n of poles 20-1 to 20-n is provided so as to be uniformly distributed across the cylinder, n being equal to 8. Even though in principle the implementation does not require multipole fields of an order higher than quadrupoles, for the compensation of mechanical imperfections it is desirable to have a facility for generating higher-order fields, for example n=8, or n=12. The cylinder axis coincides with the optical axis 102 of the particle-optical apparatus shown in figure 1.

The various multipole fields, i.e. the magnetic fields as well as the electrostatic fields, are generated by n poles. Each of these poles is arranged to generate an electrical as well as a magnetic field. The pole faces determining said multipole fields extend parallel to the optical axis of the apparatus. Each pole 20-i is provided with an excitation coil 24-i for generating a magnetic field and with a pole cap 26-i for generating an electrical field. Each of the excitation coils 24-i and each of the pole caps 26-i can be individually excited, so that each of the desired multipole fields (electrical as well as magnetic) can be generated by means of the 8 poles 30-1 to 30-8.

The length of the corrector combined with the strength of the magnetic field is such that the path of the beam is described by one complete period of a sinusoid, hence the name $2\pi$-filter

Figure 2[b] schematically shows the fundamental rays for the prior art $C_c$ corrector shown in figure 2[a].

The prior art $C_c$ corrector comprises an ExB field from the entrance plane 201 to the exit plane 203.

When describing the behavior of a double imaging ExB type $C_c$ corrector, a convenient way is using three fundamental rays in the plane where the magnetic dipole field is aligned and three fundamental rays in the plane where the electric dipole field is aligned. The electrostatic and the magnetic field are assumed to have a constant value and orientation within the corrector (so: between the entrance plane and the exit plane), and to be zero outside the corrector.

Defining the z-axis as the axis along which the charged particles propagate in the positive direction, the x-axis as the axis along which the electrical dipole field extends and the y-axis as the axis along which the magnetic dipole field extends, the following equations describe the position of the beam:

In the xz-plane, taking only first order geometric aberrations (thus: only linear effects in the opening angle) and degree one (thus: only linear effects of the energy deviation), the axial ray can be written as:

$$x(z) = x_{disp}(z) \cdot \varepsilon + x_{gaus}(z) \cdot \alpha_0 + x_{chrom}(z) \cdot \alpha_0 \cdot \varepsilon \qquad [1]$$

with $\varepsilon = \Delta E/E_0$, and $E_0$ is the energy for which the effect of the electrical dipole field and the magnetic dipole field cancel each other, $\Delta E$ is the deviation from $E_0$, and $\alpha_0 = dx/dz$ at the entrance of the corrector.

Similarly, in the yz-plane, the axial ray can be written as

$$y(z) = y_{gaus}(z) \cdot \beta_0 + y_{chrom}(z) \cdot \beta_0 \cdot \varepsilon \qquad [2]$$

with $\beta_0 = dy/dz$ at the entrance of the corrector. Note that the dispersion ray in the yz-plane is always zero, and thus coincides with the axis. This is the result of the magnetic field being aligned in this yz-plane.

The fundamental rays are thus:

- two Gaussian rays, $x_{gaus}(z)$ in the xz-plane and $y_{gaus}(z)$ in the yz-plane, each describing the trajectory of a ray with the nominal energy at opening angle $\alpha_0$;
- one dispersion ray $x_{disp}(z)$ in the xz-plane, describing the deviation of an axial electron in the x-direction as a result of an energy change; and
- two chromatic rays, $x_{chrom}(z)$ in the xz-plane and $y_{chrom}(z)$ in the yz-plane, describing the change of the Gaussian ray (with opening angle $\alpha_0$) for an energy change

It is noted that in the prior art filter shown in figure 2[a] the two Gaussian rays in the xz and the yz plane are identical, i.e. have identical deviations from the axis.

Figure 2[b] schematically shows the fundamental rays for the corrector shown in figure 2[a], the corrector extending from an entrance plane 201 at z = -30 mm to an exit plane 203 at z = +30 mm, showing a symmetry mid-plane 202 at z=0. The object for the corrector positioned at the entrance of the corrector at z = -30 mm (implying that the Gaussian rays intersect the axis at z = -30 mm).

Figure 2[b] schematically show the Gaussian rays $x_{gaus}(z)$ in the xz-plane, represented by line 204, and $y_{gaus}(z)$ in the yz-plane, represented by line 205, the dispersion ray $x_{disp}(z)$ represented by line 206, and the two chromatic rays two chromatic rays, $x_{chrom}(z)$ in the xz-plane represented by line 207 and $y_{chrom}(z)$ in the yz-plane represented by line 208, respectively.

As the corrector is double-focusing (thus: focusing in both the xz- and the yz-plane), the Gaussian ray 204 in the xz-plane intersects the z-axis at the same position as the Gaussian ray 205 in the yz-plane, at the foot of arrow 209.

The chromatic correction ($C_c$ correction) occurs due the term $x_{chrom}(z) \cdot \alpha_0 \cdot \varepsilon$ and $y_{chrom}(z) \cdot \beta_0 \cdot \varepsilon$ respectively, describing that particles entering the filter under an angle and with an energy different from the central energy exit the filter under another position than particles with the nominal energy.

Figure 3ª schematically shows the corrector/filter according to the invention.

Figure 3ª shows two identical corrector sections 301, 302, each mechanically identical to one half of the corrector shown in figure 2ª, although in working the excitation may differ. The sections are placed side by side on the same rotational (optical axis) 102, with a drift space between them. For the simulations shown here the first section extends from z = -30 mm to z = - 5 mm, and the second section from +5 mm to +30 mm. Between the two sections, in the field free region, a diaphragm 303 is placed with an aperture 304. The aperture may be a round hole, or it may resemble a knife edge. The beam 305, showing energy dispersion, is centered over the aperture, and only a selected part of the charged particles (electrons, ions) passes through the aperture. The second section brings the beam back to the axis 102, so that the beam does not show energy dispersion when leaving the second section.

It is noted that the beam as shown here deviates from the optical axis due to the magnetic field in the two sections, and thus the beam in the xz-plane is shown. In the direction perpendicular to the plane shown, the yz-plane, no such deviation occurs.

Figure 3ᵇ schematically shows the principal rays of the corrector/filter shown in figure 3ª

Figure 3ᵇ shows similar trajectories as figure 2ᵇ, but now for a corrector/filter with a first section, causing magnetic and electrical fields for -30 mm < z < -5 mm (length 210) and a second section causing fields for 5 < z < 30 mm (length 212), separated by a field free region for -5mm < z < 5 mm (length 211).

Comparing figure 2ᵇ and 3ᵇ the following differences are identified:

- The position for the object of the filter in figure 3ᵇ, described by the position where the Gaussian beams 204 and 205 intersect the axis, is slightly shifted to a position within the physical envelope of the filter, i.e. it is an imaginary object at position z = -29 mm. Likewise the exiting Gaussian beam seems to originate from a position within the filter: back-tracing the beam gives a virtual image at z ≈ +29 mm.

- When back-tracing the exiting chromatic rays 207 and 208 in figure 3ᵇ they do not intersect at the position where the Gaussian beams exit This means that the corrector/filter shows chromatic astigmatism. This implies that this corrector is only fit to correct a lens with different chromatic aberration coefficients in two direction. This is an unlikely situation, and therefore an unwanted property of a corrector.

Figure 3ᶜ schematically shows the principal rays of the corrector/filter shown in figure 3a, in which a hexapole field is used to correct the chromatic astigmatism of the filter/corrector.

It is known from ïnhomogeneous Wien filter as a corrector compensating for the chromatic and spherical aberration of low-voltage microscopes", H. Rose, Optik 84 No 3 (1990), p 91-107, more specifically paragraph 4.2, above formula 64, that a suitably oriented hexapole can eliminate axial chromatic astigmatism. Figure 3ᶜ shows the principle rays for a corrector with added hexapole. It is noted that in these simulations the hexapole field can be an electrostatic or a magnetic hexapole field, or a combination thereof, and that the field shows mirror symmetry with respect to the mid plane (z = 0) with the same sign/orientation for the two parts (the part for -30 mm < z < -5 mm and the part for +5 mm < z < +30 mm). The field free region (-5 mm < z < 5 mm) is still a field free region, and thus no hexapole field is present in this region.

Simulations show for a nominal energy of 500 meV a dispersion at the mid-plane (where the energy selective slit resides) of 25 $\mu$m/V. Blurring by coma limits the obtainable energy filtering to approximately 10 eV.

It is noted that at high currents electron-electron interactions limit the achievable filtering action. The introduction of additional quadrupoles, resulting in a astigmatic focus and thus filtering in a line focus, may be advantageous in such a condition.

Surprisingly the negative $C_c$ of the corrector, represented by the top of arrow 209 (or at least proportional to the length of arrow 209), is 3.7 times larger than in the prior art corrector, implying that for a similar excitation of the Wien filter a lens with a larger (positive) chromatic aberration can be corrected.

It is noted that the improvement with a factor 3.7 times is an improvement for this configuration only (length of both modules 25 mm, drift space 10 mm), and that other ratio's of the length of the modules and the drift space results in other improvement factors.

It is further noted that by exciting the multipoles appropriately additional dipole fields can be generated for centering the beam onto the aperture and, when exiting the corrector/filter, on the axis. Another example is that a physical implementation of a dipole, generating both a dipole and a hexapole field (at a fixed ratio).

It is mentioned that a properly excited multipole can generate several multipole fields at once. For example, a dodecapole (12-pole) can simultaneously generate a dipole field, a quadrupole field and a hexapole field in any orientation.

It is also noted that the width of the aperture determines the energy filtering. By forming the aperture as a triangle, and positioning the beam at a position with a specific width of the triangle, the energy filtering can be tuned for a specific requirement, in which a large transmitted energy spread relates to a larger transmitted current than when only a small energy spread is transmitted.

**Claims**

1.  A charged-particle apparatus (100) for inspecting or machining a sample (110), the charged-particle apparatus equipped with

    • a charged particle source (104) for producing a beam of charged particles,
    • source optics,
    • a $C_c$ corrector (108), and
    • one or more lenses (114) showing chromatic aberrations,

    where the $C_c$ corrector is a Wien-type $2\pi$ double-focusing corrector equipped to correct the chromatic aberrations of at least one of the lenses,
    **characterized in that**
    the $C_c$ corrector comprises two separate modules (301, 302), the two modules separated by a drift space, the first module (301) between the source and the second module (302), each module formed as a $1\pi$ filter, the image formed by the first module showing energy dispersion, said image acting as the object of the second module, said second module countering the chromatic dispersion of the first module, and an energy selecting slit (304) or an energy selecting aperture located in the drift space between the two modules at the image of the first module, as a result of which the $C_c$ corrector is equipped to act as an energy filter.

2.  The charged-particle apparatus of claim 1 in which the two separate modules (301, 302) are identical to each other.

3.  The charged-particle apparatus of any of the preceding claims in which the first and the second module each comprise a multipole for generating a hexapole field, said hexapole fields for correcting residual chromatic astigmatism.

4.  The charged-particle apparatus of any of the preceding claims in which the first and the second module each comprise a multipole for generating a quadrupole field, said quadrupole fields for correcting residual chromatic astigmatism.

5.  The charged-particle apparatus of any of the preceding claims in which at least the first module (301) is equipped with one or more multipoles for producing one or more dipole fields for positioning the beam relative to the slit or aperture (304).

6.  The charged-particle apparatus of any of the preceding claims in which the corrector is equipped to form an astigmatic cross-over on the slit or aperture.

7.  The charged-particle apparatus of any of the preceding claims in which the module is equipped to operate at a fixed potential relative to the source (104) and the one or more lenses (114) are equipped to operate at a selectable potential relative to the source.

8.  The charged-particle apparatus of any of the preceding claims in which the apparatus is equipped to accelerate the beam between the corrector and the one or more lenses.

9.  The charged-particle apparatus of claim 7 in which the fixed potential is a potential less than 10 keV and the selectable potential is a potential above 10 keV, more specifically above 40 keV, most specifically above 80 keV.

10. The charged-particle apparatus according to any of the preceding claims in which the apparatus is an apparatus from the group of scanning transmission electron microscopes, transmission electron microscopes, scanning electron microscopes, focused ion beam machines, or any combination thereof.

11. The charged-particle apparatus according to any of claims 1-9 in which the charged particle source (104) is an electron source or an ion source.

12. The charged-particle apparatus according to any of the preceding claims in which in working the beam of charged particles impinges on a sample.

13. The charged-particle apparatus according to claim 12 in which the charged particles entering the corrector are charged particles transmitted through the sample.

14. The charged-particle apparatus according to claim 13 in which the sample is placed between the source and the corrector and the image formed by the first module is an image of the sample.

15. The charged-particle apparatus according to any of claims 1-11 in which, in working, the source is a sample to be inspected, and the charged particles emerge from the sample as a result of irradiation of the sample with light or particulate radiation.

**100**

104

102

106

108

112

110

114

116

120

118

**FIG. 1**

FIG. 2ª

## FIG. 2$^b$

301   304   303   302

305

102

## FIG. 3$^a$

210   211   212

205
204
206

208
207
201
202
203

X- and Y-axis [a.u.]

-30   0   +30

Z-axis [mm]

## FIG. 3$^b$

**FIG. 3ᶜ**

Europäisches
Patentamt

European
Patent Office

Office européen
des brevets

## EUROPEAN SEARCH REPORT

**Application Number**

EP 12 17 1725

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 5 290800 A (JEOL LTD) 5 November 1993 (1993-11-05) * abstract; figure 1 * ----- | 1-5, 10-15 | INV. H01J37/153 |
| Y | US 2009/014649 A1 (NAKASUJI MAMORU [JP] ET AL) 15 January 2009 (2009-01-15) * paragraphs [0039] - [0049]; figures 1,4,11 * ----- | 1-5, 10-15 | |
| A | US 2009/218506 A1 (NAKASUJI MAMORU [JP] ET AL) 3 September 2009 (2009-09-03) ----- | 1 | |

| | | | TECHNICAL FIELDS SEARCHED (IPC) |
|---|---|---|---|
| | | | H01J |

The present search report has been drawn up for all claims

| Place of search | Date of completion of the search | Examiner |
|---|---|---|
| Munich | 14 November 2012 | Oestreich, Sebastian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 12 17 1725

This annex lists the patent family members relating to the patent documents cited in the above-mentioned European search report.
The members are as contained in the European Patent Office EDP file on
The European Patent Office is in no way liable for these particulars which are merely given for the purpose of information.

14-11-2012

| Patent document cited in search report | Publication date | Patent family member(s) | Publication date |
|---|---|---|---|
| JP 5290800 A | 05-11-1993 | NONE | |
| US 2009014649 A1 | 15-01-2009 | KR 20070116260 A<br>US 2009014649 A1<br>WO 2006101116 A1 | 07-12-2007<br>15-01-2009<br>28-09-2006 |
| US 2009218506 A1 | 03-09-2009 | US 2009218506 A1<br>WO 2007013398 A1 | 03-09-2009<br>01-02-2007 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0868739 B1
- US 8035082 B2
- US 20080290264 A1
- US 5986269 A

### Non-patent literature cited in the description

- **H. ROSE.** It is known from ïnhomogeneous Wien filter as a corrector compensating for the chromatic and spherical aberration of low-voltage microscopes. *Optik,* 1990, vol. 84 (3), 91-107